# EUROPEAN PATENT APPLICATION

(11) **EP 2 136 416 A1**
(43) Date of publication of application: **23.12.2009**
(21) Application number: 08721816.0
(22) Date of filing: 11.03.2008
(51) Int. Cl.: H01L 35/34, H01L 35/32, H02N 11/00

(54) **PROCESS FOR MANUFACTURING THERMOELECTRIC CONVERSION MODULE AND THERMOELECTRIC CONVERSION MODULE**

(30) Priority: 22.03.2007 JP 2007075450
(71) Applicant: Sumitomo Chemical Company, Limited, Tokyo 104-8260 (JP)
(72) Inventor: HIROYAMA, Yuichi, Tsukuba-shi Ibaraki 300-2617 (JP); UCHIDA, Yoshio, Moriya-shi Ibaraki 302-0115 (JP)
(74) Representative: Hart-Davis, Jason
(86) International application number: PCT/JP2008/054400
(87) International publication number: WO 2008/114653

(57) **Abstract**

A process for manufacturing thermoelectric conversion modules according to the present invention comprises the steps of: forming a thermoelectric green base material 13, the thermoelectric green base material 13 including a green frame member including an insulating ceramic powder and a binder and having a plurality of holes that are formed so as to extend parallel to each other in a predetermined direction; and a thermoelectric element raw material 10 placed in the holes and including a raw material powder of a thermoelectric material; and stretching the thermoelectric green base material 13 in the predetermined direction in which the holes extend.

## Description

### Technical Field

The present invention relates to a process for manufacturing a thermoelectric conversion module and to a thermoelectric conversion module.

### Background Art

Conventionally, there is known a thermoelectric conversion module comprising an insulating frame having a plurality of through-holes spaced apart from each other and provided therein; an N-type semiconductor compound element and a P-type semiconductor compound element formed by alternately filling these through-holes; and a plurality of electrodes for electrically connecting a pair of N-type semiconductor compound elements and P-type semiconductor compound elements in series in the order of N, P, N, and P on an upper surface and lower surface of the frame (for example, see Patent Document 1).
Patent Document 1 JP 08-153899 A

### Disclosure of the Invention

### Problems to be solved by the Invention

In the thermoelectric conversion module, a high output power can be obtained by increasing the element density of thermoelectric elements per unit area. In order to increase the thermoelectric element (semiconductor compound element) density of the thermoelectric conversion module described in the above Patent Document 1, it is necessary to reduce the opening area and narrow the spacing between the through-holes into which a thermoelectric element material is filled.

However, if the opening area of the through-hole is reduced, it becomes difficult to fill the thermoelectric element material into the through-hole. Therefore, there is a limit also in increasing the thermoelectric element density.

Then, the present invention has been made in view of such circumstances. It is an object of the present invention to provide a process for manufacturing a thermoelectric conversion module and a thermoelectric conversion module capable of easily increasing the density of thermoelectric elements.

### Means for Solving the Problems

A process for manufacturing thermoelectric conversion modules according to the present invention comprises the steps of: forming a thermoelectric green base material, the thermoelectric green base material including a green frame member including an insulating ceramic powder and a binder and a plurality of holes that are formed so as to extend parallel to each other in a predetermined direction; and a thermoelectric element raw material placed in the holes and including a raw material powder of a thermoelectric material; and drawing out the thermoelectric green base material in the predetermined direction in which the holes extend. Here, "green" in the present invention refers to a state prior to a firing step the thermoelectric base material that is performed subsequent to the step of drawing out the thermoelectric base material.

According to the process for manufacturing thermoelectric conversion modules of the present invention, first, a thermoelectric green base material is formed, which includes a green frame member including an insulating ceramic powder and a binder and a plurality of holes that are formed so as to extend parallel to each other in a predetermined direction; and a thermoelectric element raw material placed in the holes and including a raw material powder of a thermoelectric material Then, the thermoelectric green base material is drawn out in the predetermined direction in which the holes extend. The green thermoelectric base material is drawn out in the predetermined direction in which the holes extend, so that the area of a cross section perpendicular to this predetermined direction is reduced. As a result, in this cross-sectional direction, the cross-section area of the thermoelectric element raw material is reduced and also the spacing between the thermoelectric element raw materials is narrowed, so that the density of thermoelectric elements can be increased easily as compared with that before being drawn out in the predetermined direction.

The step of forming the thermoelectric green base material preferably comprises the steps of: forming the green frame member including the plurality of holes opened in one end face thereof; and filling the thermoelectric element raw material into the holes. This allows a hole having a relatively large opening area and a wide spacing to be formed in the green frame member before drawing out the thermoelectric green base material in the predetermined direction, and it is therefore possible to fill the thermoelectric element raw material into the holes easily. Moreover, the plurality of holes preferably extends through from the one end face of the green frame member to the other end face. This allows the thermoelectric element raw material to be filled into the holes more easily.

The step of forming the thermoelectric green base material preferably comprises the steps of: alternately forming a plurality of thermoelectric element raw material layers including a raw material powder of the thermoelectric material and a plurality of spacer layers including the insulating ceramic powder and the binder, on a surface of a substrate including the insulating ceramic powder and the binder; and forming another substrate including the insulating ceramic and the binder on top of the thermoelectric element raw material layer and the spacer layer. This allows the spacing between the thermoelectric element raw materials, the number of stacked substrates, and the like to be adjusted, and it is therefore possible to easily obtain a thermoelectric conversion module including a desired number of elements.

In the process for manufacturing thermoelectric conversion modules according to the present invention; the thermoelectric green base material is preferably drawn out in the predetermined direction using a rolling method. This allows the thermoelectric green base material to be stretched in a predetermined direction easily.

In the process for manufacturing thermoelectric conversion modules according to the present invention, the binder of the green frame member is preferably an organic binder. This allows the thermoelectric green base material to be stretched in the predetermined direction more easily.

In the process for manufacturing thermoelectric conversion modules according to the present invention, the ceramic powder preferably includes at least one oxide selected from the group consisting of silicon oxide, calcium oxide, aluminium oxide, magnesium oxide, zirconium oxide, cerium oxide, mullite, and cordierite. This makes it possible to obtain a thermoelectric conversion module with a more insulative and heat-resistant frame member.

In the process for manufacturing thermoelectric conversion modules according to the present invention, preferably, the thermoelectric element raw material further includes an organic binder. Moreover, the raw material powder of the thermoelectric material preferably includes at least one compound selected from the group consisting of a metal complex oxide, silicide, skutterudite, a clathrate compound, a boron compound, and a Te-containing alloy. The thermoelectric green base material can be drawn out in the predetermined direction more easily because it includes an organic binder. Furthermore, since the raw material powder of the thermoelectric material includes the above-described compound, a thermoelectric conversion module can be obtained, which can employ a heat source or the like of relatively high temperature (e.g., 400 to 800°C) when the thermoelectric conversion module is used as a power generator.

In the process for manufacturing thermoelectric conversion modules according to the present invention, the organic binder preferably includes at least one resin selected from the group consisting of a cellulose-based resin, a vinyl-based resin, a polyester-based resin, a polyamide-based resin, a polyurethane-based resin, and an acrylic resin. This allows the thermoelectric green base material to be drawn out in a predetermined direction more easily.

Moreover, a thermoelectric conversion module of the present invention is obtained by the above-described manufacturing process. According to this thermoelectric conversion module, the density of thermoelectric elements per unit area can be increased using a simple manufacturing process.

### Effects of the Invention

According to the present invention, it is possible to provide a process for manufacturing a thermoelectric conversion module and a thermoelectric conversion module capable of easily increasing the density of thermoelectric elements.

### Brief Description of the Drawings

FIG 1 is a perspective view illustrating an appearance of a thermoelectric conversion module obtained by a manufacturing process of the present invention.
FIG 2 is a cross sectional view along an II-II line of the thermoelectric conversion module shown in FIG 1.

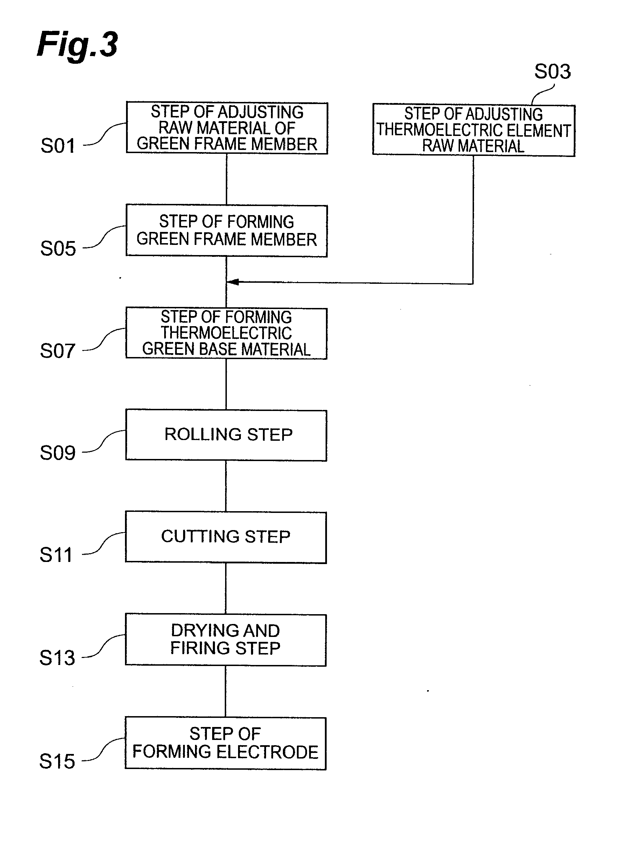

FIG 3 shows a flow of a manufacturing step of the thermoelectric conversion module according to an embodiment of the present invention.
FIG 4 is a perspective view illustrating an appearance of a green frame member in the manufacturing step of this embodiment.
FIG 5 schematically shows a rolling step in the manufacturing step of this embodiment.
FIG 6 shows the step of forming a thermoelectric green base material in a manufacturing step according to another embodiment of the present invention.

### Description of the Reference Symbols

1: thermoelectric conversion module
2: insulating frame member
3: through-hole
4: p-type thermoelectric element
5: n-type thermoelectric element
6: electrode
7, 8: I/O electrode
10: thermoelectric element raw material (thermoelectric element raw material layer)

### Modes for Carrying Out the Invention

The findings from the present invention can be easily understood by consideration of the following detailed description together with the accompanying drawings shown as examples. Embodiments of the present invention will be illustrated with reference to the accompanying drawings. If possible, the same reference numeral is given to the same element to omit the duplicated description.

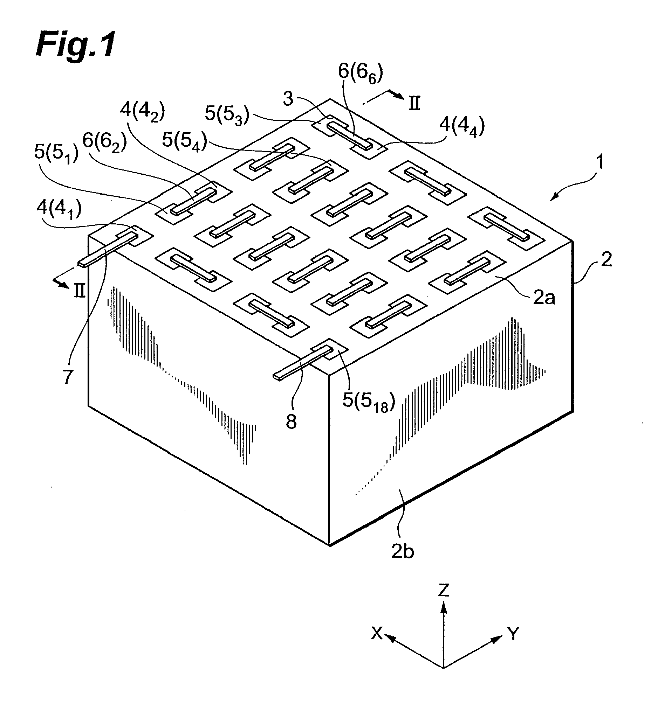

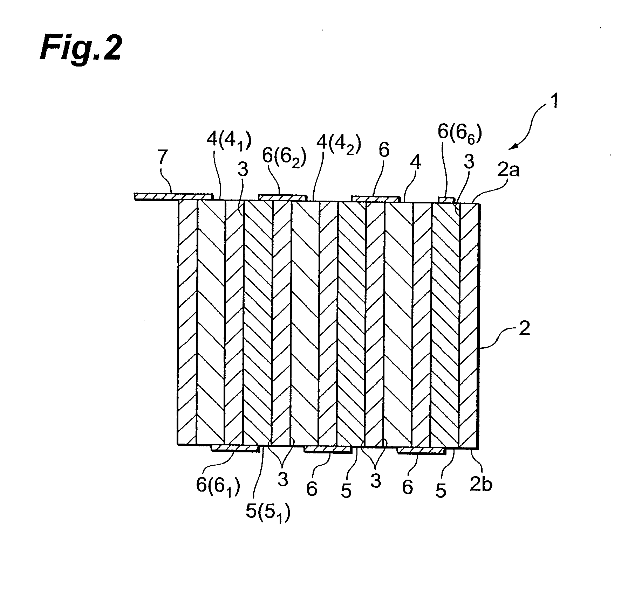

First, a thermoelectric conversion module obtained by a manufacturing process of the present invention is illustrated. As shown in FIG 1 and FIG 2, a thermoelectric conversion module 1 obtained by the manufacturing process of the present invention includes an insulating frame member 2 in the form of a cube. The insulating frame member 2 thermally and electrically insulates a plurality of thermoelectric elements described later from each other. The insulating frame member 2 preferably has resistivity not less than 10² Ωm. The insulating frame member 2 has formed therein a plurality of through-holes 3 extending through from one end face 2a to the other end face 2b in a height direction (z direction). Each of the through-holes 3 is in the form of an opening with a rectangular cross section when viewed from each of the end faces 2a, 2b, and is arranged in a lattice pattern of six rows by six columns, for example.

A p-type thermoelectric element 4 and an n-type thermoelectric element 5 are formed in each of the through-holes 3. These p-type thermoelectric elements 4 and n-type thermoelectric elements 5 are alternately formed in a row direction (x direction) and a column direction (y direction). Furthermore, a plurality of electrodes 6 is provided in one end face 2a and the other end face 2b of the insulating frame member 2 so that all of the p-type thermoelectric elements 4 and n-type thermoelectric elements 5 may be electrically connected in series.

Specifically, in a p-type thermoelectric element 4₁ formed at one corner portion in a lattice arrangement, an I/O electrode 7 for connecting to the outside is formed on one end face 2a side. The p-type thermoelectric element 4₁ is electrically connected to an n-type thermoelectric element 5₁, which is adjacent to the p-type thermoelectric element 4₁ in the column direction, through an electrode 6₁ on the other end face 2b side. The n-type thermoelectric element 5₁ is electrically connected to another p-type thermoelectric element 4₂, which is adjacent to the n-type thermoelectric element 5₁ in the column direction, through an electrode 6₂ on the one end face 2a. In this manner, in each of the thermoelectric elements 4, 5 adjacent to each other in the column direction, electrical connection is repeatedly made through the electrode 6 on one end face. An n-type thermoelectric element 5₃ formed at another corner portion in the column direction is electrically connected to a p-type thermoelectric element 4₄, which is adjacent to the n-type thermoelectric element 5₃ in the row direction, through an electrode 6₆ on the one end face 2a side. Furthermore, the p-type thermoelectric element 4₄ is electrically connected to an n-type thermoelectric element 5₄, which is adjacent to the p-type thermoelectric element 4₄ in the column direction, through the electrode 6 (not shown) on the other end face 2b side. In this manner, in each of the thermoelectric elements 4, 5 adjacent to each other in the column direction and the row direction, electrical connection is repeatedly made by means of the electrode 6 on either of the end faces. An I/O electrode 8 is formed in an end face of an n-type thermoelectric element 5₁₈ that electrically serves as the other end.

Thermoelectric conversion module 1 has a relatively hotter end face 2a side and a relatively colder end face 2b side of the insulating frame member 2, and can generate an electromotive force at each of the I/O electrodes 7, 8. On the other hand, the end face 2a side of the insulating frame member 2 can be relatively hotter or colder and the end face 2b side can be made relatively colder or hotter by applying a voltage to each of the I/O electrodes 7, 8. The number of the p-type thermoelectric elements 4 and n-type thermoelectric elements 5 arranged therein is appropriately determined in accordance with the purpose of use of a thermoelectric converter because the electromotive force or the temperature difference can be adjusted by increasing or decreasing this number. The number of thermoelectric elements may be increased by arranging a plurality of the thermoelectric conversion modules 1 side by side.

Second, an embodiment of a process for manufacturing thermoelectric conversion modules according to the present invention is illustrated with reference to a flowchart of a manufacturing step shown in FIG 2.

### <Step of preparing the raw material of a green frame member>

First, a raw material for forming a ductile green frame member is prepared (S01). The raw material of the green frame member includes an insulative ceramic powder and a binder. An organic binder or an inorganic binder can be used as the binder. Examples of the organic binder include a cellulose-based resin such as ethyl cellulose, a vinyl-based resin such as polyvinyl butyral, a polyester-based resin, a polyamide-based resin, a polyurethane-based resin, and an acrylic resin. These resins are used individually or in combination with another or more. Examples of the inorganic binder include glass. As the binder, an organic binder is preferably used because it facilitates drawing out of a thermoelectric green base material described later. Furthermore, the raw material of the green frame member is preferably a ceramic paste including a ceramic powder and a binder. This is prepared by charging a ceramic powder, a binder, solvent, and the like into a ball mill, and mixing and kneading these for a predetermined time. The ceramic powder is not limited in particular as long as it is insulative, and a highly insulative oxide which is fired at a predetermined temperature are preferable, and examples thereof include silicon oxide, calcium oxide, aluminium oxide, magnesium oxide, zirconium oxide, cerium oxide, mullite, and cordierite. Among these, in light of low thermal conductivity, the ceramic powder is preferably zirconium oxide, cerium oxide, mullite, or cordierite. These oxides are used individually or in combination with another or more. The ceramic powder with an average particle of about 0.1 to 10 µm is preferably used. With the average particle diameter less than 0.1 µm, the green frame member tends to have a decreased strength. On the other hand, when the average particle diameter exceeds 10 µm, the green frame member is less likely to retain a predetermined shape.

Examples of the solvent include organic solvent such as terpineol, butyl carbitol, acetone, toluene, xylene, ethanol, methyl ethyl or ketone. These solvents are used individually or in combination with another or more.

The amount of the binder is preferably 1 to 30 parts by weight per 100 parts by weight of the ceramic powder, and is particularly preferably 2 to 10 parts by weight. When the amount is less than one part by weight, the thermoelectric green base material after being drawn out tends to have a decreased strength. When the amount exceeds 30 parts by weight, the thermoelectric base material after being fired tends to have a decreased strength. The amount of the solvent is preferably 10 to 150 parts by weight per 100 parts by weight of the ceramic powder, and is particularly preferably 50 to 100 parts by weight. When the amount is less than 10 parts by weight, the thermoelectric green base material after being drawn out is likely to be fragile. When the amount exceeds 150 parts by weight, the thermoelectric green base material after being draw out tends to have a decreased strength.

In addition to the above-described ones, about 0.5 to 5 parts by weight of plasticizer such as phthalate ester or adipate ester, a dispersant, other insulator such as a glass frit, or the like per 100 parts by weight of the ceramic powder may be added into the raw material of the green frame member.

### <Step of preparing the thermoelectric element raw material>

Apart from the raw material of the green frame member, the thermoelectric element raw material placed in a later-described hole of the green frame member is prepared (S03). The thermoelectric element raw material includes a raw material powder of the thermoelectric material. The raw material powder of the thermoelectric material includes the following ones. Examples of the raw material powder of a p-type thermoelectric material include metal mixed oxide such as Ca₃Co₄O₉ or NaₓCoO₂, silicides, such as MnSi_{1.73}, Fe₁₋ₓWnₓSi₂, Si_{0.8}Ge_{0.12}, or β-FeSi₂, skutterudites such as CoSb₃, FeSb₃, or RFe₃CoSb₁₂ (R represents La, Ce, or Yb), and Te-containing alloys, such as BiTeSb, or PbTeSb. Examples of the raw material powder of an n-type thermoelectric material include metal mixed oxide such as SrTiO₃, Zn₁₋ₓAlₓO, CaMnO₃, LaNiO₃, BaₓTi₈O₁₆, or Th₁₋ₓNbₓO, silicides such as M_{g2}Si, Fe₁₋ₓCOₓSi₂, Si_{0.8}Ge_{0.2}, or β-FeSi₂, skutterudites, clathrate compounds such as Ba₈Al₁₂Si₃₀ or BagAl₁₂Ge₃₀, boron compounds such as CaB₆, SrB₆, BaB₆, or CeB₆, and Te-containing alloys such as BiTeSb or PbTeSb. Among these, in light of the manufacturing cost and the stability in the atmosphere, a raw material powder of the thermoelectric material is preferably a metal mixed oxide, and a combination of Ca₃Co₄O₉ as the raw material powder of the p-type thermoelectric material and CaMnO₃ as the raw material powder of the n-type thermoelectric material is particularly preferable. These raw material powders of the thermoelectric materials can be used suitably for a power generator using an especially high temperature heat source, because these raw material powders, when used as a thermoelectric element, exhibit excellent thermoelectric properties at about 700 to 800°C in particular. The raw material powder of the thermoelectric material with an average particle diameter of about 0.1 to 10 µm is preferably used. When the average particle diameter is less than 0.01 µm, the composition of the thermoelectric element is likely to vary depending on the powder composition and the thermoelectric element characteristics may vary. On the other hand, when the average particle diameter exceeds 10 µm, the thermoelectric element characteristics, in particular an electrical conducting property, may degrade depending on the powder composition. As the raw material powder of the thermoelectric material, a powder furthermore serving as a raw material of the above-described raw material powder may be used. For example, when the thermoelectric material is a mixed oxide, a metal salt such as a carbonate of each metal can be used.

In addition to the raw material powder of the thermoelectric material, the thermoelectric element raw material preferably includes an organic binder because it facilitates drawing out of the thermoelectric green base material described later. Examples of the organic binder include a cellulose-based resin such as ethyl cellulose, a vinyl-based resin such as polyvinyl butyral, a polyester-based resin, a polyamide-based resin, a polyurethane-based resin, and an acrylic resin. These resins are used individually or in combination with another or more. the thermoelectric element raw material is preferably a thermoelectric raw material paste including a raw material powder of the thermoelectric material. This is prepared by charging a raw material powder of the thermoelectric material, an organic binder, and solvent and the like into a ball mill, and mixing and kneading these for a predetermined time. The thermoelectric element raw material dispersed only with solvent and the like, without using an organic binder, may be used. Examples of the solvent include organic solvent such as terpineol, butyl carbitol, acetone, toluene, xylene, ethanol, methyl ethyl or ketone. These solvents are used individually or in combination with another or more.

The amount of the organic binder is preferably 0.5 to 10 parts by weight per 100 parts by weight of the raw material powder of the thermoelectric material, and is particularly preferably 1 to 5 parts by weight. When the amount is less than 0.5 parts by weight, the thermoelectric element raw material after being placed in the hole tends to have a void formed therein. When it exceeds 10 parts by weight, the fired thermoelectric elements tends to have a decreased fired density. The amount of the solvent is preferably 10 to 150 parts by weight per 100 parts by weight of the raw material powder of the thermoelectric material, and is particularly preferably 50 to 100 parts by weight. When the amount is less than 10 parts by weight, the thermoelectric element raw material after being placed in the hole tend to have a void formed therein. When it exceeds 150 parts by weight, thermoelectric element raw material after being placed in the hole also tends to have a void formed therein.

Furthermore, in addition to the above-described ones, about 0.5 to 5 parts by weight of plasticizer such as phthalate ester or adipate ester, a dispersant, a glass frit, an insulator, or the like per 100 parts by weight of the raw material powder of the thermoelectric material may be added into the raw material powder of the thermoelectric material.

### <Step of forming the green frame member>

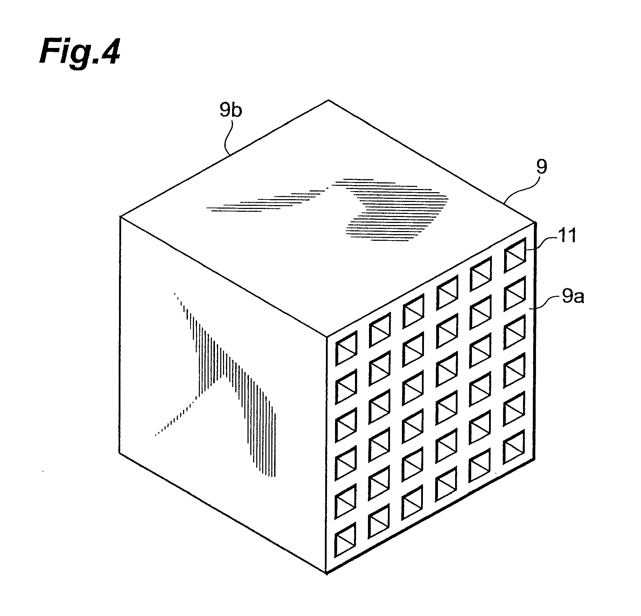

Next, using the raw material of the green frame member prepared in the above-described step, a cubic green frame member 9 with a plurality of holes 11 as shown in FIG 4 is formed (S05). The green frame member 9 can be prepared, for example, by forming a compact having the holes 11 with a rectangular opening that extends through from one end face 9a to other end face 9b using an extrusion method or the like, followed by drying the compact at a predetermined temperature, as needed, to volatilize the solvent. The green frame member 9 is a composite material including a ceramic and a binder, and is ductile because the binder is included, and the green frame member 9 can be transformed in a rolling step described later. For this reason, the hole 11 of the green frame member 9 can be formed with the opening area thereof about 1.5 to 5 times as large as the opening area of the through-hole 3 of the insulating frame member 2. The green frame member 9 may include a plurality of holes each having an opening formed only on one end face side.

### <Step of forming the thermoelectric green base material>

Subsequently, the thermoelectric green base material is formed by filling and placing the thermoelectric element raw material, which was prepared in the above-described step, into the holes 11 of the green frame member 9 (S07). When a p-type thermoelectric element and an n-type thermoelectric element are formed in the holes 11, first, a mask having an opening formed at a position corresponding to each of the holes 11 to be filled with the raw material of the p-type thermoelectric element is arranged (not shown) on one end face 9a of the green frame member 9, and then the raw material of the p-type thermoelectric element is filled into the predetermined holes 11. A mask having an opening formed at a position corresponding to each of the holes 11 to be filled with the raw material of the n-type thermoelectric element is arranged (not shown), and the raw material of the n-type thermoelectric element is filled into the rest of the holes 11. After filling each of the raw materials of the thermoelectric elements, these raw materials are dried at a predetermined temperature, as needed, to volatilize the solvent. Thereby, a thermoelectric green base material having the raw materials of the thermoelectric elements arranged therein, the raw materials of the thermoelectric elements each including the raw material powder of each of the thermoelectric materials, can be formed. The thermoelectric element raw material is fluid or ductile because it includes a raw material powder of the thermoelectric material and contains an organic binder or solvent as needed. Then, since the fluid or ductile thermoelectric element raw material is formed in the hole 11 of the ductile green frame member 9, the formed thermoelectric green base material is also ductile. In a rolling step described later, the thermoelectric element raw material can be transformed according to a change in the opening shape of the hole 11. In order to improve the filling characteristic of the thermoelectric element raw material, the thermoelectric element raw material may be pulled from the other end face 9b side of the green frame member 9 using a suction apparatus.

### <Rolling step>

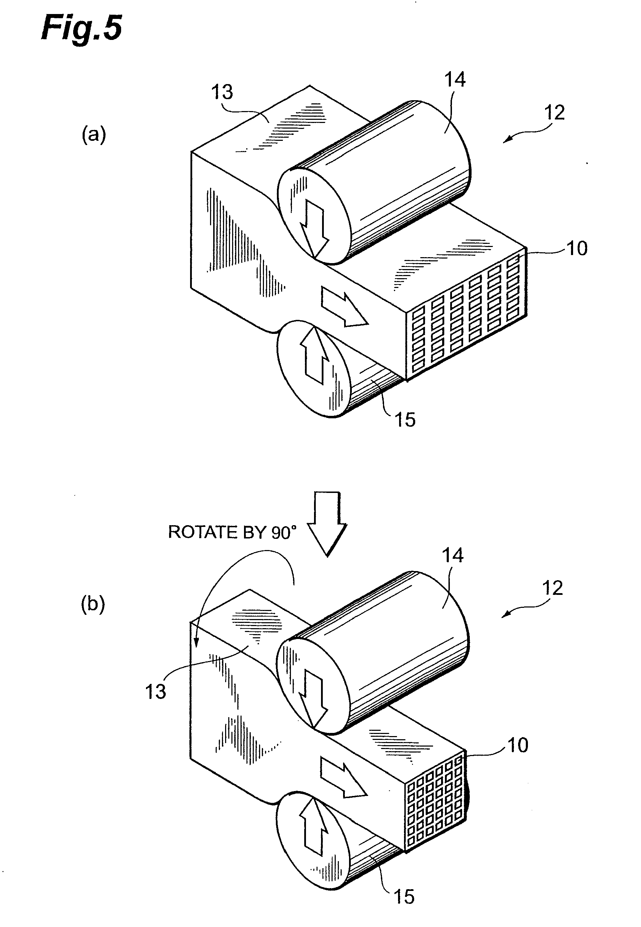

Subsequently, the ductile thermoelectric green base material is drawn out in the direction in which the holes extend (S07). As shown in FIG 5, a rolling method can be used in the drawing out, for example. As a rolling mill 12, an apparatus can be used, which includes a set of mill rolls 14, 15 so as to be able to press in the vertical direction when viewed from the end face direction of a thermoelectric green base material 13. When using such an apparatus, first, the thermoelectric green base material 13 is vertically rolled so as to transform the cross section thereof from a substantially square shape into a laterally extending rectangular shape (a). Accordingly, the cross-sectional shape of the thermoelectric element raw material 10 is also transformed into a rectangular shape. Then, the transformed thermoelectric green base material 13 is rotated by 90 degrees when viewed from the end face direction, and in this state the thermoelectric green base material 13 is vertically rolled again (b). By repeating the rolling in these two directions about 2 to 10 times, the cross-section area when viewed from the end face direction of the thermoelectric green base material 13 can be reduces. Moreover, the rolling in these two directions can make the cross-sectional shape of the thermoelectric green base material 13 and the cross-sectional shape of the thermoelectric element raw material 10 generally analogous before and after the rolling.

In one rolling, the percentage reduction (rolling ratio) of the size in the pressurizing direction of the thermoelectric green base material is preferably 5 to 20%, and is particularly preferably 10 to 15%. When the percentage reduction is less than 5%, the number of times of rolling may increase. When it exceeds 20%, a crack or the like is likely to occur in the thermoelectric green base material. The heating temperature of the mill rolls 14, 15 may be appropriately set in accordance with the type, blending quantity, or the like of the binder used for the thermoelectric green base material, or may be set to a normal temperature without heating.

A rolling mill including 2 sets of mill rolls capable of rolling in the vertical direction and the lateral direction may be used. In this case, the manufacturing time can be reduced because the rolling is possible from two directions at the same time.

### <Cutting step>

Next, the rolled thermoelectric green base material is cut into a predetermined length as needed in the longitudinal direction (S 11). In the cutting, a conventional cutting method using a rotary cutter, a laser, or the like can be used.

### <Drying and firing step>

Subsequently, the thermoelectric green base material is fired at about 800 to 1600°C (S13). When the raw material of the green frame member includes an organic binder, the thermoelectric green base material is preferably heated at about 400 to 800°C to decompose and remove the organic binder, prior to firing. A thermoelectric base material including the insulating frame member 2 and the thermoelectric elements 4, 5 can be formed by firing the thermoelectric green base material. Shrinkage due to this firing can reduce the cross-section area of the thermoelectric base material further. An apparatus such as a hot press or a plasma discharge firing apparatus can be used in firing. In the rolling step, rolling and firing may be performed at the same time by performing rolling at high temperature of about 800 to 1600°C.

### <Step of forming electrodes>

Then, in both end faces of the thermoelectric base material after firing, electrodes for electrically connecting the thermoelectric elements in series are formed (S 15). The electrodes can be formed using a thin film technology such as sputtering or vapor deposition, or using screen printing, plating, or the like. Metal or an alloy can be used as the material of the electrodes. Examples of the material on the relatively hotter side of the thermoelectric conversion module include metal such as Zr, Au, Ag, Pt, Pd, Cu, Ti, Ni, Mo, Zn, W, or V, and an alloy of these metals. On the other hand, examples of the material on the relatively colder side include metal such as Bi, Sn, Ag, Cu, Pt, Al, Au, Fe, Mo, Zn, or Pb, or an alloy of these metals. Electrodes using these materials can be used suitably for power generators using an especially high temperature heat source because these electrodes can improve heat resistance, corrosion resistance, and the adhesiveness to the thermoelectric element.

Finally, the thermoelectric conversion module 1 as shown in FIG. 1 can be obtained by forming the I/O electrodes and an insulating shield.

In the above-described process for manufacturing thermoelectric conversion modules according to this embodiment, first, the thermoelectric green base material 13 is formed, which includes the green frame member 9 including an insulating ceramic powder and a binder and having a plurality of holes that are formed so as to extend parallel to each other in a predetermined direction; and the thermoelectric element raw material 10 placed in the holes and including a raw material powder of a thermoelectric material. Then, the thermoelectric green base material 13 is drawn out in the predetermined direction in which the holes extend. The thermoelectric green base material 13 is drawn out in the predetermined direction in which the holes extend, so that the area of the cross section perpendicular to this predetermined direction is reduced. As a result, in this cross-sectional direction, the cross-section area of the thermoelectric element raw material 10 is reduced and the spacing between the thermoelectric element raw materials 10 is narrowed, so that the density of thermoelectric elements can be increased easily as compared with that before being drawn out in the predetermined direction.

The step of forming the thermoelectric green base material 13 includes the steps of: forming the green frame member 9 having the plurality of holes 11 opened in one end face; and filling the thermoelectric element raw material includes the raw material powder of the thermoelectric material into the holes 11. Thereby, the hole 11 with a relatively large opening area and a wide spacing can be formed in the green frame member 9 before drawing out the thermoelectric green base material 13 in the predetermined direction, and it is therefore possible to fill the thermoelectric element raw material into the hole 11 easily. , The plurality of holes 11 extends through from the one end face 9a of the green frame member 9 to the other end face 9b. This allows the thermoelectric element raw material to be filled into the hole more easily.

In the thermoelectric conversion module 1 obtained by the manufacturing process according to this embodiment, the density of thermoelectric elements per unit area can be increased using a simple manufacturing process.

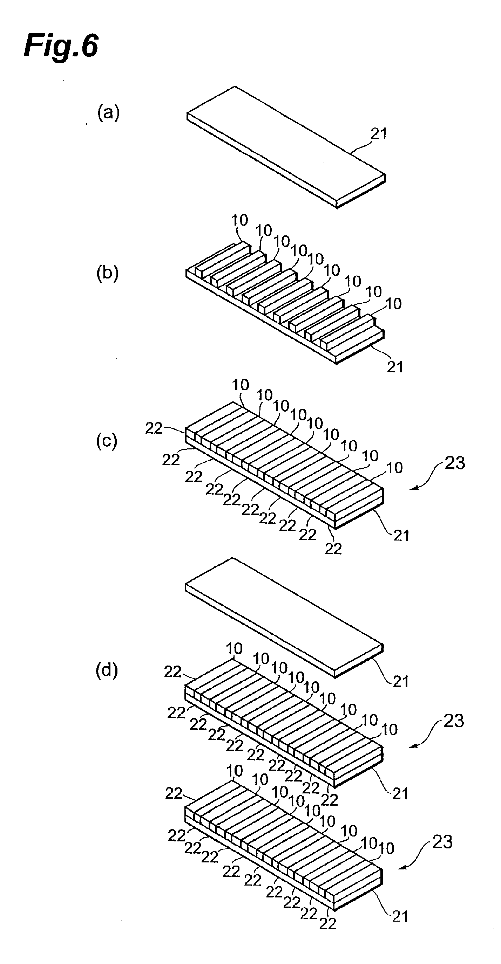

A process for manufacturing thermoelectric conversion modules according to another embodiment is illustrated with reference to FIG 6. The embodiment is the same as the above-described embodiment except for the step of forming the ductile thermoelectric element.

### <Step of forming the substrate>

A substrate 21(a) is formed using the above-described raw material of the green frame member (e.g., a ceramic paste). The above-described ceramic paste is applied onto a carrier film such as a PET (polyethylene terephthalate) film, using a thick film forming technique, such as a doctor blade method, and then is dried at about 130 to 200°C to remove the solvent. In this manner, a ceramic green sheet in the form of a sheet having a thickness of about 0.5 to 5 mm per layer can be formed. Then, a substrate 21 of about 1 to 5 mm can be prepared by laminating one, or two or more ceramic green sheets.

A spacer layer 22 can be prepared by cutting the above-described substrate 21 into a predetermined width.

### <Step of forming a thermoelectric element raw material layer>

A thermoelectric element raw material layer 10 is formed using the above-described thermoelectric element raw material (e.g., thermoelectric raw material paste). First, as with the substrate 21, the above-described thermoelectric raw material paste is applied onto a carrier film such as a PET (polyethylene terephthalate) film using a thick film forming technique such as a doctor blade method,and then is dried at about 130 to 200°C to remove the solvent. In this manner, a thermoelectric element green sheet in the form of a sheet having a thickness of about 0.5 to 5 mm per layer can be formed. A thermoelectric element sheet of about 1 to 5 mm is prepared by laminating one, or two or more thermoelectric element sheets. Then, the thermoelectric element raw material layer 10 can be formed by cutting this thermoelectric element sheet into a predetermined width.

### <Step of Lamination>

In the surface of the substrate 21, a predetermined number of thermoelectric element raw material layers 10 are spaced from each other and arranged (b) so that the longitudinal direction of the thermoelectric element raw material layers 10 may be along the width direction of the substrate 21. Then, by arranging the spacer layer 22 between the plurality of thermoelectric element raw material layers 10 adjacent to each other (c), a module board 23 having the thermoelectric element raw material layer 10 and the spacer layer 22 alternately formed in the substrate 21 is formed. The order of arrangement of the thermoelectric element raw material layer 10 and the spacer layer 22 is not limited in particular. The spacer layers 22 may be arranged first, followed by arranging the thermoelectric element raw material layer 10 therebetween, or the thermoelectric element raw material layer 10 and the spacer layer 22 may be alternatively arranged. Thermoelectric element raw material layer 10 and the spacer layer 22 may be formed by printing a thermoelectric raw material paste and a ceramic paste to the substrate 21, respectively, by screen printing.

The ductile thermoelectric green base material 13 can be formed by laminating a predetermined number of module boards 23 described above and furthermore laminating the substrate 21 onto the uppermost layer (d).

In the above-described process for manufacturing thermoelectric conversion modules according to this embodiment, the step of forming the thermoelectric green base material includes the steps of: alternately forming a plurality of thermoelectric element raw material layers 10 including a raw material powder of the thermoelectric material and the spacer layers 22 including an insulating ceramic powder and a binder, on the surface of the substrate 21 including an insulating ceramic powder and a binder; and forming another substrate 51 including an insulating ceramic and a binder on the thermoelectric element raw material layer 10 and the spacer layer 22. Accordingly, the spacing between the thermoelectric element raw material layers 10, the number of stacked layers, and the like can be adjusted, and it is therefore possible to easily obtain a thermoelectric conversion module including a desired number of elements.

In the foregoing paragraphs, the preferred embodiments of the present invention have been illustrated, however, the present invention is not limited to the above-described embodiments.

## Claims

1. A process for manufacturing a thermoelectric conversion module, comprising the steps of:
forming a thermoelectric green base material, the thermoelectric green base material including a green frame member including an insulating ceramic powder and a binder and a plurality of holes that are formed so as to extend parallel to each other in a predetermined direction; and a thermoelectric element raw material placed in the holes and including a raw material powder of a thermoelectric material; and
drawing out the thermoelectric green base material in the predetermined direction in which the holes extend.

2. The process for manufacturing a thermoelectric conversion module according to claim 1, wherein the step of forming the thermoelectric green base material comprises the steps of:
forming the green frame member having the plurality of holes opened in one end face thereof; and
filling the thermoelectric element raw material into the holes from the one end face side.

3. The process for manufacturing a thermoelectric conversion module according to claim 2, wherein the plurality of holes extends through from the one end face of the green frame member to the other end face.

4. The process for manufacturing a thermoelectric conversion module according to claim 1, wherein the step of forming the thermoelectric green base material comprises the steps of:
alternately forming a plurality of thermoelectric element raw material layers including a raw material powder of the thermoelectric material and a plurality of spacer layers including the insulating ceramic powder and the binder on a surface of a substrate including the insulating ceramic powder and the binder; and
forming another substrate including the insulating ceramic and the binder on the thermoelectric element raw material layer and the spacer layer.

5. The process for manufacturing a thermoelectric conversion module according to any one of claims 1 to 4, wherein the thermoelectric green base material is drawn out in the predetermined direction by a rolling method.

6. The process for manufacturing a thermoelectric conversion module according to any one of claims 1 to 5, wherein the binder of the green frame member is an organic binder.

7. The process for manufacturing a thermoelectric conversion module according to any one of claims 1 to 6, wherein the ceramic powder includes at least one oxide selected from the group consisting of silicon oxide, calcium oxide, aluminium oxide, magnesium oxide, zirconium oxide, cerium oxide, mullite, and cordierite.

8. The process for manufacturing a thermoelectric conversion module according to any one of claims 1 to 7, wherein the thermoelectric element raw material further includes an organic binder.

9. The process for manufacturing a thermoelectric conversion module according to any one of claims 1 to 8, wherein the raw material powder of the thermoelectric material includes at least one compound selected from the group consisting of a metal mixed oxide, silicide, skutterudite, a clathrate compound, a boron compound, and a Te-containing alloy.

10. The process for manufacturing a thermoelectric conversion module according to claim 6 or 8, wherein the organic binder includes at least one resin selected from the group consisting of a cellulose-based resin, a vinyl-based resin, a polyester-based resin, and a polyamide-based resin, a polyurethane-based resin, and an acrylic resin.

11. A thermoelectric conversion module obtained by the manufacturing process according to any one of claims 1 to 10.
